# EUROPEAN PATENT APPLICATION

(11) **EP 3 379 278 A1**
(43) Date of publication of application: **26.09.2018**
(21) Application number: 17161785.5
(22) Date of filing: 20.03.2017
(51) Int. Cl.: G01R 31/36, H01M 10/48, B60L 11/18

(54) **BATTERY ENERGY STORE**

(71) Applicant: ABB Schweiz AG, 5400 Baden (CH)
(72) Inventor: MARINOPOULOS, Antonis, 54636 Thessaloniki (GR); MISYRIS, Georgios, 57001 Thessaloniki, (GR); TENGNER, Tomas, 722 41 Västerås (SE)
(74) Representative: Helin, William

(57) **Abstract**

The present invention relates to a method for enabling dynamic evaluation of performance of a battery energy store. The method comprises measuring (2) real-time parameters (V, I, T) of a battery energy store (1), estimating (3) a state of charge (SOC) for the battery energy store, the estimation being based on the measured real-time parameters and off-line data (4) of the energy store, identification (3) of R-C parameters for an equivalent circuit model (ECM) of the battery energy store, the identification being based on the measured real-time parameters, updating (5) a look-up table with the identified R-C parameters for different operating conditions, and simulating (5) performance of the battery energy store based on two or more operating conditions. A system, a marine vessel and a computer program product thereof are also presented.

## Description

### TECHNICAL FIELD

The invention relates to enable dynamic evaluation of performance of a battery energy store, and a system thereof.

### BACKGROUND

The use of Battery Energy Storage Systems (BESS) for a number of different applications has started to increase, mainly due to cost reduction of battery cells. New trends are making BESS a necessary part of the system, either to handle grid challenges from the increasing integration of intermittent renewable generation into the electric power system, or to achieve further electrification of systems in order to reduce emissions (e.g. cars, trains, ships, etc.).

Regarding optimized operation of a BESS, except the obvious requirements for safety, accurate estimation of the State of Charge (SOC) and the State of Health (SOH) of the batteries is a quite challenging task. Dynamically calculating the decrease of the capacity and the increase of the internal resistance of the battery due to degradation is also important. Moreover, applications that require high energetic performance from a BESS are much different in their technical specifications requirement from power demanding applications. Thus, in order to ensure that the BESS will be able to perform as expected for a specific application for a given time period, it is crucial to identify as soon as possible critical degradation, especially for critical applications like for example spinning reserve BESS for ships, hybrid ships or ships with dynamic positioning.

A Battery Management System (BMS) estimates two main parameters, i.e. the state of charge (SOC) and the state of health (SOH) for the battery. Since the SOC cannot be measured directly, various methods are used to determine its value, the most common one being the current integration (or Coulomb counting), where the SOC is calculated by measuring the battery current and integrating it in time. However, since all measurements include errors, this method suffers from long-term drift and lack of a reference point. Thus, the SOC must be re-calibrated on a regular basis, which might not be convenient in a real-life demanding application. The SOH calculation depends on the performance requirements of each specific application and depends on a good estimation of the remaining capacity.

Moreover, as the BESS is operating it also degrades, which affects not only the remaining capacity, but also the technical characteristics of the BESS, such as the internal resistance. Thus, an estimation of the internal parameters of the battery cells is also important, in order to be able to identify as soon as possible critical degradation of a cell which can jeopardize the performance of the battery.

### SUMMARY

An object of the invention is to enable fast identification of possible critical degradation of a battery energy storage system.

According to a first aspect, there is presented a method for enabling dynamic evaluation of performance of a battery energy storage. The method comprises measuring real-time parameters of a battery energy store, estimating a state of charge for the battery energy store, the estimation being based on the measured real-time parameters and off-line data of the energy store, identification of R-C parameters for an equivalent circuit model of the battery energy store, the identification being based on the measured real-time parameters, updating a look-up table with the identified R-C parameters for different operating conditions, and simulating performance of the battery energy store based on two or more operating conditions.

The battery energy store may be used to operate a marine vessel, such as propelling or positioning the marine vessel.

The battery energy store may be a battery energy store system (BESS).

The method may further comprise estimating a hybrid SOC parameter based on the estimated SOC and a SOC calculation. For estimation of the hybrid SOC parameter, the estimated SOC and the SOC calculation may be combined weighted with a time parameter, such that for an older battery energy store the estimated SOC are more relevant than the calculated SOC, and for a newer battery energy store the calculated SOC is more relevant than the estimated SOC.

The battery energy store may comprise a plurality of batteries, the method may further comprise excitation of the battery energy store, including increasing a current charge/discharge for one or more of the plurality of batteries, and decreasing a current charge/discharge for one or more of the plurality of batteries, wherein a total current charge/discharge for the plurality of batteries is kept unchanged.

The method may comprise comparing the total current before and after the excitation of the battery energy store to estimate SOC.

According to a second aspect, there is presented a system for enabling dynamic evaluation of performance of a battery energy store. The system comprises a battery energy store, a real-time measurement module for measuring real-time parameters of the battery energy store, an off-line data module for storing off-line data of the battery energy store, a state of charge estimation module for estimation of the SOC of the battery energy store, wherein the estimation being based on measured real-time parameters and off-line data of the energy store, an identification module, wherein R-C parameters for an equivalent circuit model of the battery energy store are identified, the identification being based on the measured real-time parameters, an update module for updating a look-up table with the identified R-C parameters for different operating conditions, and a simulation module for performance simulation of the battery energy store based on two or more operating conditions.

A marine vessel is also presented.

According to a fourth aspect, there is presented a computer program product for enabling dynamic evaluation of performance of a battery energy store.

The computer program product comprises computer program code stored on a computer readable storage means, the computer program code, when run on a system, causes the system to measure real-time parameters of a battery energy store, estimate a state of charge for the battery energy store, the estimation being based on the measured real-time parameters and off-line data of the energy store, identify of R-C parameters for an equivalent circuit model of the battery energy store, the identification being based on the measured real-time parameters, update a look-up table with the identified R-C parameters for different operating conditions, and simulate performance of the battery energy store based on two or more operating conditions.

Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated.

### BRIEF DESCRIPTION OF THE DRAWINGS

The invention is now described, by way of example, with reference to the accompanying drawings, in which:
Fig. 1 schematically illustrates a system enabling dynamic evaluation of a BESS;
Fig. 2 shows three diagrams, schematically illustrating simulation of BESS scenarios;
Fig. 3 schematically illustrates a system enabling dynamic evaluation of a BESS;
Fig. 4 schematically illustrates an implementation of a hybrid SOC estimation method;
Fig. 5 schematically illustrates a system enabling dynamic evaluation of a BESS;
Fig. 6 schematically illustrates forced excitation;
Fig. 7 schematically illustrates a system for enabling forced excitation;
Fig. 8 schematically illustrates a load profile for LFP test;
Fig. 9 schematically illustrates estimation compared to test measurements; and
Fig. 10 schematically illustrates the absolute error of the estimation shown in Fig. 9.

### DETAILED DESCRIPTION

The invention will now be described more fully hereinafter with reference to the accompanying drawings, in which certain embodiments of the invention are shown. This invention may, however, be embodied in many different forms and should not be construed as limited to the embodiments set forth herein; rather, these embodiments are provided by way of example so that this disclosure will be thorough and complete, and will fully convey the scope of the invention to those skilled in the art. Like numbers refer to like elements throughout the description.

In this invention, a system is described, where the SOC and the Capacity of an operating battery are estimated on-line, using real-time measurements. The parameters of an Equivalent Circuit Model (ECM) of the battery are also identified. In this document, the scope is to show how to use these estimations in combination with off-line data of the battery and information about the loading profile, in order to continuously evaluate the performance of the BESS and act in a proactive way in order to ensure a safe operation in an optimal way.

The benefits of dynamically evaluating the BESS performance can be summarized as: optimize the battery operation, operate the battery in a safe operating range, identify degradation of the battery in a timely manner, and ensure performance of battery for a specific time period.

System described herein can be implemented in many different BESS applications, like grid applications, industrial applications, marine applications, traction applications, etc.

The goal of the proposed system is to dynamically evaluate the performance of a BESS in order to ensure the safe and optimal operation for a specific period of time fulfilling the expected performance requirements for a specific application.

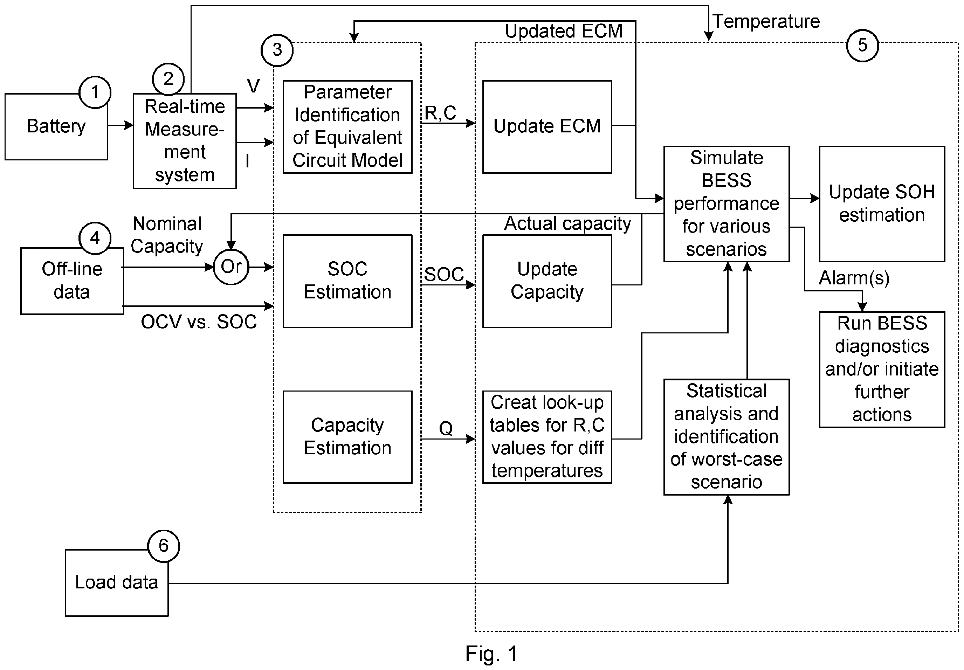

The system, as shown in Fig. 1 includes at least one battery, or a battery module, or a battery rack or a complete BESS 1, a measurement system with sensors, transducers and communication channels to transfer the real-time measurements 2, a computer device 3, which receives real-time inputs from the measurement system and off-line data 4 and uses them to perform a combination of algorithms in order to estimate the SOC, capacity and parameters of the ECM, a second computer device 5 which receives the previous estimations and data regarding the load of the battery 6 and performs calculations to dynamically, update the capacity and the ECM of the battery and continuous simulations to update the SOH and perform an early diagnosis in case of critical degradation of the battery.

The battery 1 represents a generic BESS, where a number of battery cells are connected in parallel and series configuration forming battery modules and racks and controlled by one or more BMS.

The real-time measurement system 2 takes measurements, including voltage (V), current (I) and temperature (T), from one or more battery cells/modules/racks and transmits them to the computer device for further processing.

The computer device 3 has input/output units to receive data from the measurement system and from offline databases, memory where the computer software and the data are stored and processing power to execute the computer software, which includes the combination of ECM parameter estimation, SOC estimation, and capacity estimation algorithms.

The off-line data 4 may come from other databases and can include the OCV vs. SOC curve of the battery as provided from the manufacturer, look-up tables, nominal characteristics of the battery, etc.

The second computer device 5 receives the estimations performed from the first computer software, real-time measurements from the measurement system and also data regarding the performance requirements from the load profile of the battery, and performs data analyses, simulations of the battery operation, calculations and updates on the ECM and the capacity and other functions. The objective of these functions are to optimize the operation of the battery ensuring that it can fulfil the load requirements, to update the battery model parameters for various voltage and temperature operational regions and to timely diagnose undesired conditions, due to degradation or abnormal operation of the battery.

The load data 6 may be actual real-time load values, historical data of load profile, or forecasts, or stochastic data, or synthetic load profiles or other load scenarios or combinations of the above.

In this paragraph it is in more detail described how the system for dynamic performance evaluation is set up and methods are presented through examples through which the BESS continuously simulates one or more worst case scenarios with updated data in order to achieve the desired operation and safety. The description is referred to Fig. 1, and more specific to module 5.

### Update ECM

This block receives the values of the ECM parameters (resistances and capacitances) as calculated from a real-time parameter identification and comparing them with their initial values decides if and when to update the ECM. Then it sends the updated model back to module 3.

### Update Capacity

This block receives the value of the battery capacity as estimated from the real-time capacity estimation and comparing it with its initial value and taking into account the time period that has elapsed decides if and when to update it. Then it sends the updated capacity back to module 3, replacing the initial nominal capacity.

### Create look-up tables

The ECM models a battery using an R-C electrical circuit, with a number of resistances and capacitances connected in series and in parallel. The values of these parameters are ideally independent from the current flowing through the battery, thus the electrical equivalent. However, in reality they can be dependent on the charge/discharge current.

This can be mainly attributed to their dependence on the battery temperature, especially the instantaneous series resistance, which varies according to the current. Therefore, one more function inside module 5 is dedicated into creating, and constantly updating, look-up tables for the R-C parameters of the ECM for different operating regions, i.e. different temperatures and currents.

### Processing and analysis of load data

This block receives inputs from module 6, which provides different kind of load data, and performs various statistical analyses. It can create statistics for example about max and min load values, frequency and duration of cycles, identification of load patterns, depth of discharge requirements, power and energy requirements, etc. Based on the type of battery and on the performance requirements for a given time period, the block creates a number of possible worst-case scenarios in order to feed the simulation block.

Optionally the worst-case scenario(s) are a static set of load profiles defined by the system requirement specification. In that case this block may just feed these static worst case load profiles to the "simulation block", without additional analysis on the data received by module 6.

### Simulate BESS

This block receives the updated ECM and the updated value for the capacity. It also receives load data statistics, worst-case scenarios, different load patterns, etc. from the previous block. Finally, it can take into account the look-up tables that have been created inside the corresponding block (even if they are partially complete).

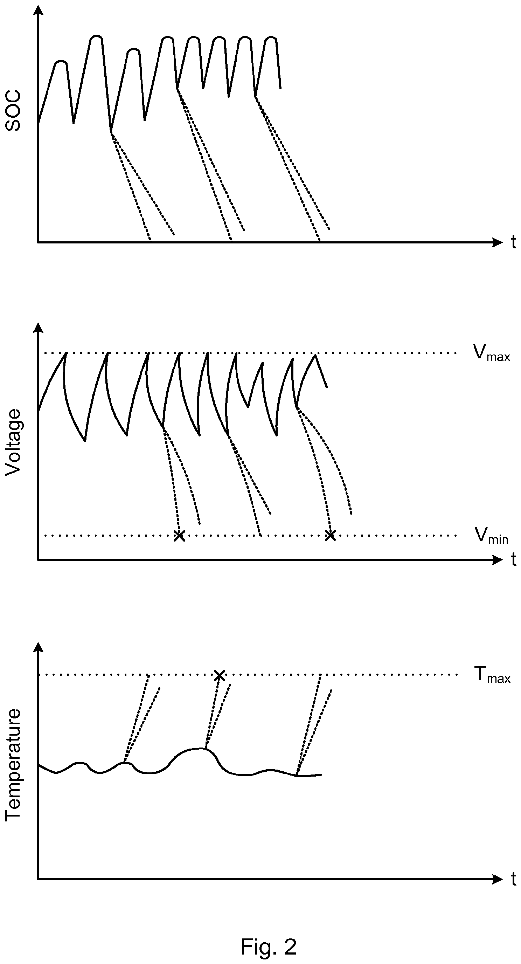

Fig. 2 illustrates worst case worst-case scenario simulations on a BESS that is within the safe operation range (left) and on one that is outside the safe operation range due to reduced capacity and higher impedance (right). The curves represent measured/estimated values on the physical system. BESS Voltage (V) and Temperature (T) depend on both the remaining BESS capacity and the voltage drop due to impedance.

Fig. 2 illustrate worst-case scenario simulations on a BESS that is within the safe operation range (right) and on one that is outside the safe operation range due to reduced capacity and higher impedance (left). The BESS that is outside the safe operation region may be an aged BESS with reduced capacity and higher internal impedance.

### Update SOH estimation

In this block the State of Health (SOH) of the battery is updated. Through the updated ECM parameters, the updated capacity estimation and the simulation of the BESS performance, the SOH is re-calculated and if found to have changed more than a predefined limit, it is updated and the new value is communicated to the user.

### BESS diagnostics

In case the simulation of the BESS produces any abnormal results, it can create various alarm signals. This block receives such signals and performs an analysis of the results in order to diagnose any issues with the BESS. These issues could be for example the detection of an unusually high value of the internal resistance of a battery cell, a big change in SOH, a sudden decrease in the capacity of the battery, etc. Also, when simulating worst case operation scenarios an alarm can be given if the projected performance of the BESS cannot meet the defined technical requirements specification.

The block can inform the user of the diagnostic results and based on a set of guidelines for troubleshooting, suggest a number of remedial actions.

Although a remaining capacity of a BESS is important, its accurate estimation is easier than the on-line estimation of SOC, which can be crucial, especially for critical applications like example back-up BESS for ships.

Since the SOC cannot be measured directly, various methods are used to determine its value, the most common one being the current integration (or Coulomb counting (CC)), where the SOC is calculated by measuring the battery current and integrating it in time. However, since all measurements include errors, this method suffers from long-term drift and lack of a reference point. Thus, the SOC must be re-calibrated on a regular basis, which might not be convenient in a real-life demanding application.

By modelling a battery with an ECM, different methods to identify the parameters of this model may be used and they may be updated dynamically as the battery operates and also make better estimation of the SOC and the remaining capacity. However, all model-based methods are very much dependent on the observability of the system, i.e. the degree of excitation that is an input for the different estimation algorithms. Finally, the form of the SOC vs. OCV curve can have a big impact on the estimation, especially in high non-linear or in very "flat" operating regions.

An embodiment is presented on alternative ways to combine a number of SOC estimation methods with the well-known Coulomb Counting (current integration), in order to increase the accuracy of SOC estimation for an on-line system. The combinations of these methods will provide a more robust solution for different types of batteries, different condition of the same battery, different charging/discharging profiles, and different operating regions. The benefits of a more accurate state estimation of the battery can be summarized as: optimize the battery operation, operate the battery in a safe operating range, and ensure performance of battery for a specific time period.

A system is described, where the SOC and the capacity of an operating battery are estimated on-line, using real-time measurements. The parameters of an ECM of the battery are also identified.

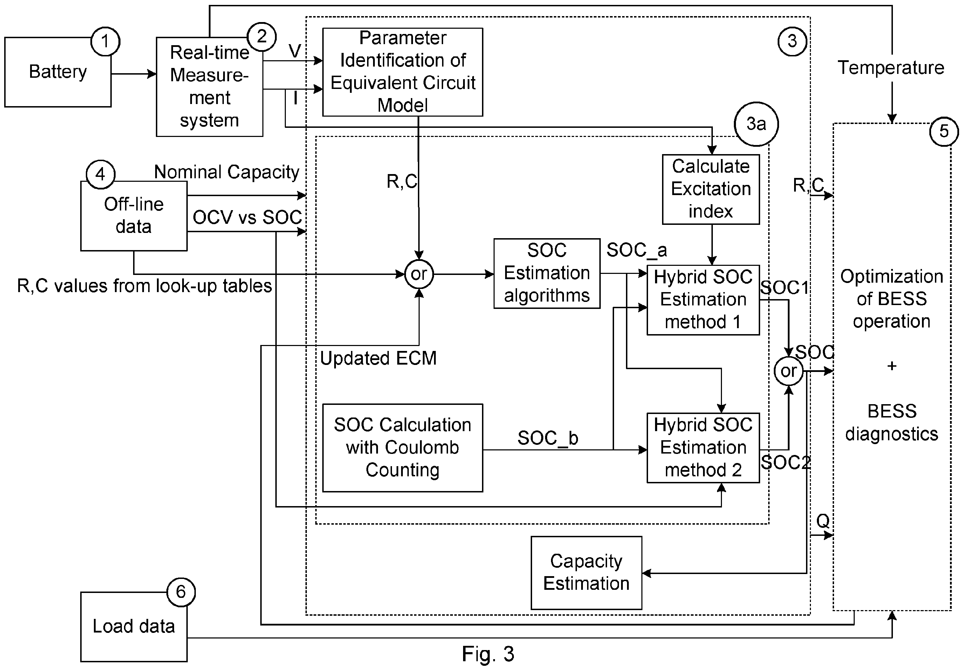

The system, as shown in Fig. 3 includes: at least one battery 1, or battery module, or battery rack or complete BESS and their corresponding BMS, power converters, and controls a measurement system 2 with sensors, transducers and communication channels to transfer the real-time measurements, a computer device 3, which receives real-time inputs from the measurement system and off-line data 4 and uses them to perform a combination of algorithms in order to estimate the SOC, capacity and parameters of the ECM, a second computer device 5 which receives the previous estimations and data regarding the load of the battery 6 and performs calculations to optimize the battery performance The module 3, particularly subsystem 3a, which performs the SOC estimation is present in more detail. The addition of the Coulomb Counting (CC) method for calculating the SOC and the combination of this with the SOC Estimation algorithms is provided in order to provide hybrid methods for improved SOC estimation.

The different modules in Fig. 3 are described hereafter.

Module 1 represents one or more BESS, where each BESS consists of a number of battery cells connected in parallel and series configuration forming battery modules and racks and controlled by one or more BMS. The power electronic converters used to charge/discharge the batteries are included this module.

The real-time measurement system 2 takes measurements, including voltage, current and temperature, from one or more battery cells/modules/racks and transmits them to the computer device for further processing.

The computer device 3 has input/output units to receive data from the measurement system and from offline databases, memory where the computer software and the data are stored and processing power to execute the computer software, which includes the combination of ECM parameter estimation, SOC estimation, and capacity estimation algorithms.

The off-line data 4 may come from other databases and can include the OCV vs SOC curve of the battery as provided from the manufacturer, look-up tables, nominal characteristics of the battery, etc.

The second computer device 5 receives the estimations performed from the first computer software, real-time measurements from the measurement system and also data regarding the performance requirements from the load profile of the battery, and performs off-line calculations to optimize the operation of the battery and to timely diagnose undesired conditions, due to degradation or abnormal operation of the battery.

The load data 6 may be actual real-time load values, historical data of load profile, or forecasts, or stochastic data, or synthetic load profiles or other load scenarios or combinations of the above.

Methods are described in more detail, in order to make the SOC estimation of BESS more robust.

### Parameter identification of Equivalent Circuit Model

This block receives inputs of voltage and current from the real-time measurement system and possibly also from the off-line data module and performs an on-line identification of the ECM parameters. Its outputs, i.e. values of the resistances and capacitances of the ECM, are then fed to the SOC Estimation algorithms.

### Capacity Estimation

This block uses the value of SOC as estimated by the appropriate blocks and also information from the on-line current measurements and estimates the remaining capacity of the battery.

### SOC Estimation Algorithms

This block receives as inputs the parameters of the ECM, and information from the off-line data module and performs model based on-line SOC estimation.

R-C parameters of the ECM can be received alternatively from two other sources other than the parameter identification block.

For a relative new battery one option is to receive the ECM parameters directly from the off-line data module, which includes look-up tables of those parameters for the specific type of the battery. This can facilitate a quicker and more accurate SOC estimation, based on the fact that for a relative new battery the internal parameters do not change significantly, thus the SOC estimation algorithms can better rely on the provided initial R-C values from a look-up table, avoiding the unavoidable error from the on-line parameter identification methods.

For an aged battery an alternative option is to receive the updated ECM parameters from module 5. In that way, instead of using the estimated parameters from the on-line identification block, the SOC estimation algorithms can rely on updated look-up tables.

### SOC Calculation with Coulomb Counting

This block performs the well-known CC method to calculate the SOC of the battery. It receives input from the real-time current measurements and by integrating the current it can calculate the SOC. As it has been already mentioned, this method suffers from long-term drift and lack of a reference point. However, with accurate enough current measurements, the CC can calculate the very accurately the SOC for a relative short period of time, i.e. before the unavoidable errors in current measurement accumulate and cause a drift. The output of this SOC calculation will be combined with the SOC estimated by the SOC estimation algorithms.

### Calculate Excitation Index

This block receives as an input the real-time current measurement from the real-time measurement block, in order to calculate an appropriate excitation index. The value of the index depends on the level of excitation for the specific battery and load profile. This index is fed into the Hybrid SOC Estimation Method 1 and is used to define the weighting factors for the method.

### Hybrid SOC Estimation method 1

This block includes one hybrid SOC estimation method, based on a combination of CC and model-based on-line estimation algorithms with different weighting factors. In specific, the block receives as an input one SOC estimation (SOC_a) from the SOC Estimation Algorithms block and another SOC estimation (SOC_b) from the SOC Calculation with CC block. It also, receives as an input an excitation index as calculated from the Calculate Excitation Index block. Depending on the value of this index the output of this block is a SOC estimation (SOC1) based on either a) the CC in case the index indicates a very low value of excitation, or b) the model-based SOC estimation algorithms in case the value of the index indicates a high enough excitation or c) a combination of these two SOC estimation with appropriate weighting factors attached to each of them in case the index indicates intermediate excitation conditions. In the first case, when using the CC, the SOC estimated from the last model-based estimation is taken as initial value of the SOC, avoiding the lack of reference point that is associated with CC method in general. In the third case, there are numerous ways to combine SOC_a and SOC_b, e.g. weighted average, etc.

### Hybrid SOC Estimation method 2

This block includes another hybrid SOC estimation method, based on a continuous on-line correction of the CC method with estimations from model-based algorithms. This correction is based on the fact that the CC method (that gives the SOC_b) is capable of very accurately monitoring the change of SOC in the short term (assuming accurate enough current measurements), but can eventually suffer from poor initialization and a drift in the long term. On the other hand the model-based estimation algorithms do not show any drift and can in general estimate the average SOC very accurately. However during low excitation the model-based estimation algorithms might lose their accuracy. Thus, the combined SOC estimation is more robust in the long term. This method can be implemented using various correction processes, and below two examples are presented.

In one example, the inputs for the hybrid estimation method 2 block are the SOC_a and SOC_b, as described above and the OCV-SOC curve from the Offline data module 4. The method receives the two on-line SOC estimations and stores their values for a period of time as time-series SOC_a(t) and SOC_b(t). Then in predefined time instances it calculates the average or mean value of each SOC estimation for a given time window [ti, t2]. It then compares these values avg(SOC_a(t)) and avg(SOC_b(t)) and if their difference is higher than a predefined limit a correction process is triggered. This process aims at correcting the SOC estimation by removing a possible erroneous offset of the SOC_b using the average value of SOC_a. In the general case t2 could be equal to ti.

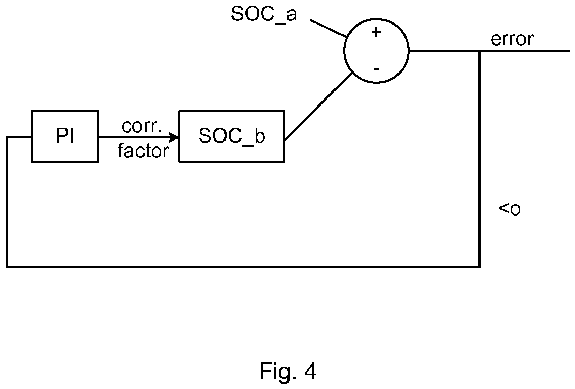

In the second example, the inputs for the hybrid estimation method 2 block are again the SOC_a and SOC_b and the OCV-SOC curve from the Off-line data module 4. The method calculates in each time t the difference between SOC_a(t) and SOC_b(t) and uses this value as an error, which is fed to a controller, PI or similar. The output of the controller is a correction factor which is then added to the output of the SOC_b. This provides a continuous correction of the drifting of SOC_b, while at the same time avoids the real-time errors of SOC_a due to low observability. A schematic of this process can be seen in Fig. 4, where CBatt is the capacity of the battery in Ah and IBatt the real-time current measurement (in sec).

An example of the implementation of Hybrid SOC Estimation method 2 is illustrated in Fig. 4.

The third input of this block, i.e. the OCV-SOC curve, can be used in order to identify the high non-linear regions of this curve, where the model-based estimation tends to be less accurate. This might be useful in case for example the model-based estimation is actually accurate enough so that it can be used alone. However, the hybrid method 2 may be implemented only for some difficult operating regions of the SOC.

Finally, as shown in Fig. 3, the final SOC output of module 3 can be either SOCi, as estimated by the Hybrid estimation method 1, or SOC2, as estimated by the Hybrid estimation method 2, depending on the specific requirements and operating conditions.

Accurate on-line estimation of SOC and capacity is crucial, especially for critical applications like for example back-up BESS for ships. By modelling a battery with an ECM, different methods can be used to identify the parameters of this model and update them dynamically as the battery operates and also make better estimation of the SOC and the remaining capacity.

The problem is that, for an on-line monitoring system, the accuracy of the parameter identification and the state estimation algorithms depends heavily on the quality or observability of the real-time measurements data. By quality, not only the accuracy of the measurements, but also their sampling frequency and their rate of change, are meant, all of which affect the information that can be extracted.

An embodiment of methods presented herein is to increase the observability of the on-line system, so that the parameter identification and the state estimation algorithms will be able to provide accurate estimation, even in cases that the real-time measurement data, in their original form, might not be able to provide enough/suitable information to the algorithms to achieve the needed state estimation accuracy. The benefits of a more accurate state estimation and a dynamically updated ECM of the battery can be summarized as: optimize the battery operation, operate the battery in a safe operating range, identify degradation of the battery in a timely manner, ensure performance of battery for a specific time period.

A system is described, where the SOC and the capacity of an operating battery are estimated on-line, using real-time measurements. The parameters of an ECM of the battery are also identified.

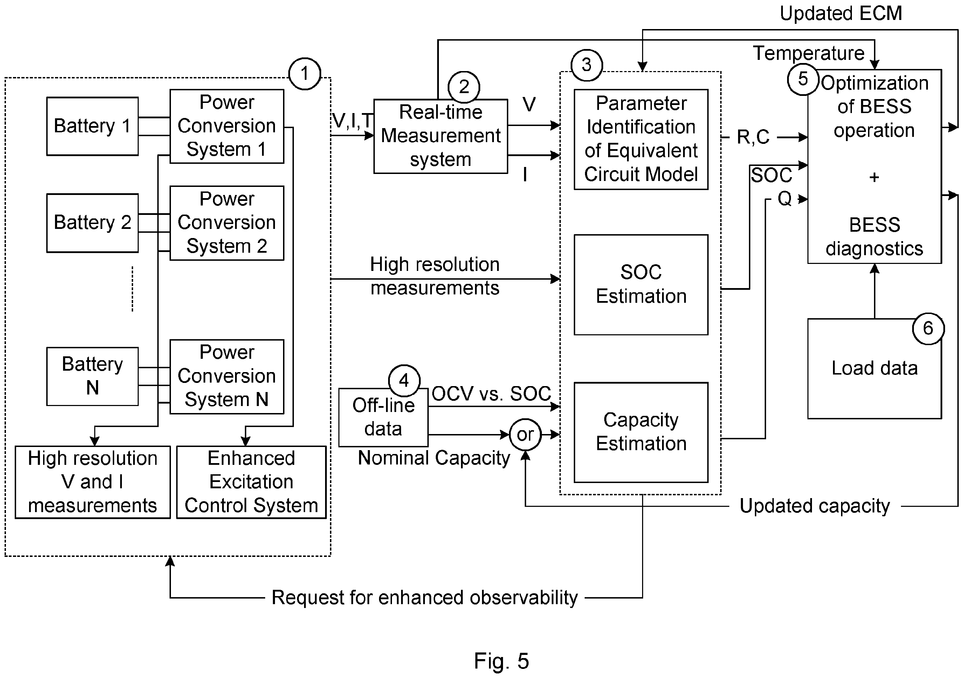

As shown in Fig. 5, the system includes at least one battery, or battery module, or battery rack or complete BESS and their corresponding BMS, power converters, and controls 1, a measurement system 2 with sensors, transducers and communication channels to transfer the real-time measurements, a computer device 3, which receives real-time inputs from the measurement system and off-line data 4 and uses them to perform a combination of algorithms in order to estimate the SOC, capacity and parameters of the ECM, a second computer device 5 which receives the previous estimations and data regarding the load of the battery 6 and performs calculations to optimize the battery performance .

The focus of this embodiment is in the part of the system, which is responsible to enhance the observability of the BESS real-time monitoring, in order to be able to achieve accurate on-line estimations of the SOC and the capacity of an operating BESS, as well as accurate parameter identification of the ECM of the battery. This is included in module 1 in Fig. 5.

The different modules in Fig. 5 are described hereafter.

Module 1 represents one or more BESS, where each BESS consists of a number of battery cells connected in parallel and series configuration forming battery modules and racks and controlled by one or more BMS. The power electronic converters used to charge/discharge the batteries are included in this module. The proposed system for enhancing the observability for better estimation is also included in this module, and will be explained in the next section.

The real-time measurement system 2 takes measurements, including voltage, current and (optionally) temperature, from one or more battery cells/modules/racks and transmits them to the computer device for further processing.

The computer device 3 has input/output units to receive data from the measurement system and from offline databases, memory where the computer software and the data are stored and processing power to execute the computer software, which includes the combination of ECM parameter estimation, SOC estimation, and capacity estimation algorithms.

The off-line data 4 may come from other databases and can include the OCV vs. SOC curve of the battery as provided from the manufacturer, look-up tables, nominal characteristics of the battery, etc.

The second computer device 5 receives the estimations performed from the first computer software, real-time measurements from the measurement system and also data regarding the performance requirements from the load profile of the battery, and performs off-line calculations to optimize the operation of the battery and to timely diagnose undesired conditions, due to degradation or abnormal operation of the battery.

The load data 6 may be actual real-time load values, historical data of load profile, or forecasts, or stochastic data, or synthetic load profiles or other load scenarios or combinations of the above.

### Battery

Module 1 may contain any number N of battery blocks, where N is at least one. Each of these blocks may be either a battery module, consisted of a number of battery cells connected in series and parallel configuration, or a battery rack (parallel/series connected modules) or a BESS (parallel/series connected battery racks). Each of these "batteries" is monitored and controlled by each own BMS.

### Power conversion system

Each battery block has its own dedicated power conversion system. This can be any kind of dc/dc or dc/ac converter, which is used to charge and discharge the battery accordingly in order to meet the load requirements.

### High resolution measurements

This block takes high resolution real-time measurements of voltage and current. These measurements may be necessary in case the sampling frequency of the real-time measurement system 2 is not high enough to provide appropriate information for an accurate parameter identification (especially for the instantaneous resistance). In this case, module 3, which performs this estimation, sends a signal to request high resolution measurements. These high resolution measurements can be collected in two ways.
A) With high resolution voltage and current sensors connected to the terminals of the battery.
B) Directly from the converter. The converter is connected to the terminals of the battery through cables and/or busbars, and controls the voltage and/or current to charge and discharge the battery. Since the switching frequency is usually rather high, by measuring the "fast" voltage response due to a "fast" current pulse, the parameter identification block in module 3 can then calculate the "instantaneous" resistance of the battery. Influence from the inductance of the battery, including inductance from connecting cables and/or busbars may be eliminated mathematically.

These high resolution measurements are then transmitted to the computer device 3, which performs the state estimations. For this, appropriate communication channels are required.

### Enhanced Excitation Control System

The SOC and/or capacity estimation algorithms require a certain level of excitation in their input in order to be able to give accurate estimations. For example, if the battery is charging for a long time with constant current, the on-line algorithms might lose the ability to estimate correctly the SOC, since the excitation (rate of change of current) might not contain enough information to properly estimate resistance and hence OCV and SOC. In that case, module 3 can send a request for enhanced observability to module 1. Then, the "Enhanced Excitation Control System" will answer to that request by properly changing the charge/discharge current of at least one of the batteries, while at the same time adjusting the current of the rest of the batteries, in order to retain the total current flowing in/out of the BESS unchanged. In other words, while fulfilling the load requirements, it redistributes the (otherwise equally distributed) load to the batteries. By this manner, it creates a forced excitation to at least one battery, so that the current sensor(s) (hence the voltage sensor(s) as well) can now record a change in their value, thus enhancing the observability of the system and helping the estimation algorithms to give a better on-line estimation.

There are more than one method through which this system can enhance the observability.
1. Increase the current of one or more batteries, while reducing the current of the remaining batteries in order to always fulfil the total load requirements.
2. Increase the time of a current pulse at one or more batteries, while taking action to always fulfil the total load requirements.
3. Modify the frequency of forced excitation pulses at one or more batteries, while always fulfilling the total load requirements.
4. Induce forced excitation in a random battery, while always fulfilling the total load requirements.
5. Induce forced excitation in all batteries sequentially one by one, while always fulfilling the total load requirements.

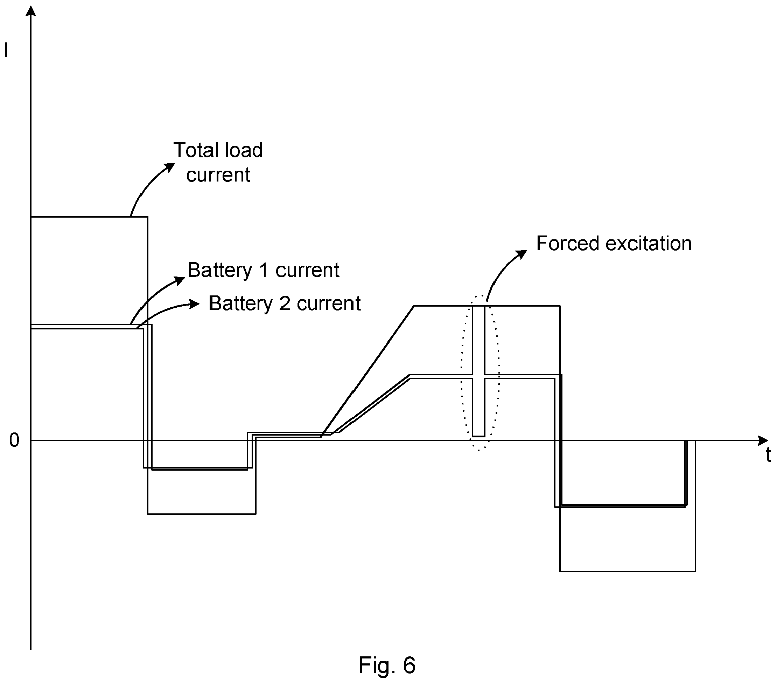

As mentioned above, the BESS should obviously fulfil the total load requirements at all times. This implies that any forced excitation action at one or more batteries should be accompanied by respective complementary actions in one or more of the remaining batteries. In Fig. 6 a simple example for a BESS with two batteries is illustrated. The total load current is defined from the application and the Battery 1 and 2 current curves are the current as distributed into the two batteries. After a period of charging with a ramping current there is a relative long period of constant current, where the estimation algorithms lack excitation to perform a good estimation. Then, module 3 requests for an enhanced observability and the enhanced excitation control system responds by forcing the excitation into battery 1 with a current pulse. At the same time the system reduces the current in battery 2, so that the total current during this forced excitation period remains the same for the load.

Thus, in order to apply the enhanced excitation methods it is necessary that the total BESS comprises at least two different batteries, as depicted by the Battery block in Fig. 5.

### Alternative method for increased observability

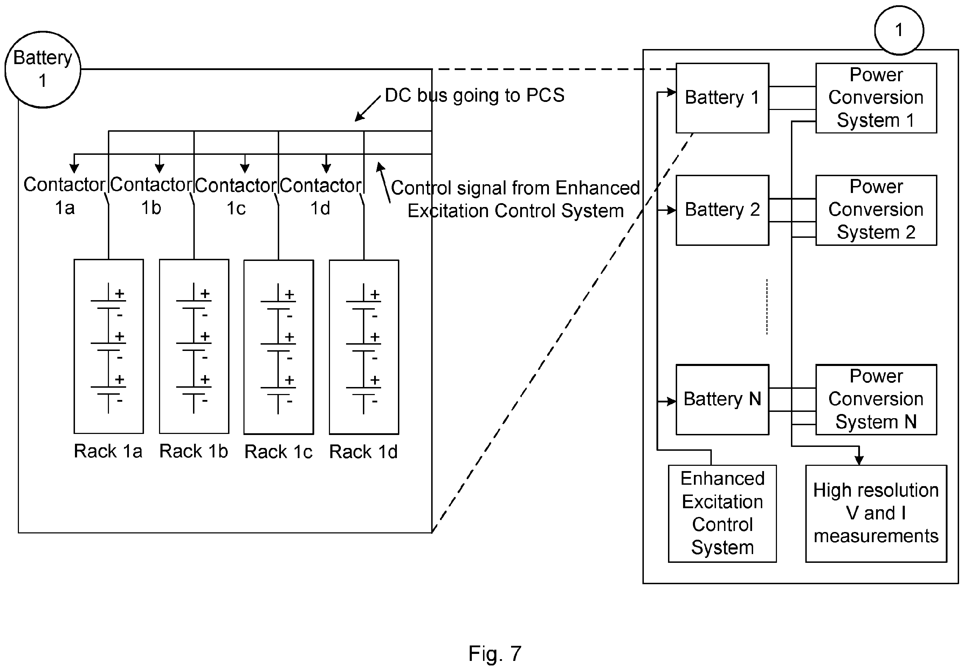

An alternative way to increase the observability is presented, which is done in the level of the Battery module, i.e. one level down from the power conversion system. In Fig. 7 a slightly different configuration of module 1 can be seen, where the enhanced excitation control system sends a control signal to the battery, instead of the Power Conversion System (PCS). In this way the system controls the opening/closing of at least one of the DC contactors that connect the battery racks to the common DC bus that goes to the PCS. Therefore, in times with low excitation it can create a forced excitation in at least one of the battery racks by disconnecting it and creating a current dip for a short period of time, while at the same time the current from/to the PCS will be redistributed to the other racks that remain connected.

The DC contactors may be mechanical contactors/breakers or static switches or a combination thereof.

A test has been performed, connecting an LFP battery cell to a PEC battery cell tester, and loading it with a specific charging/discharging profile. Voltage and current are measured by the PEC tester with very high accuracy. The current is also internally integrated with high accuracy (millisecond range), producing an accurate on-line measurement of the SOC, which will be used as the reference to compare with the SOC estimation given by our algorithms.

In the next figures the curves represent the following: REF: SOC calculated based on the accurate internal Coulomb Counting, and 2RC: SOC estimated by algorithms in module 3, based on an equivalent circuit model with 2 R-C branches.

### Test results

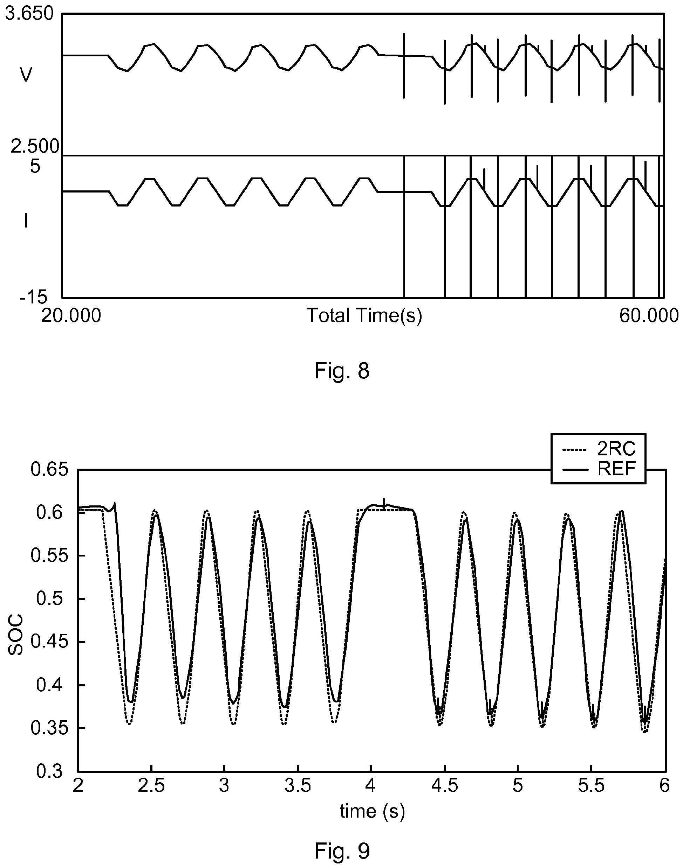

In Fig. 8 measurements of the current that was used to test the battery and the respective voltage response are illustrated. The battery starts at around 60% SOC level and is being discharged/charged between 30-35% and 60% continuously using ramping down/up and constant current. The first five cycles do not have any forced excitation, while the last five cycles include one short current pulse during each constant current charge/discharge and each ramping down current. These forced current pulses have been introduced in order to investigate if and how much does the observability change, thus the SOC estimation, as well.

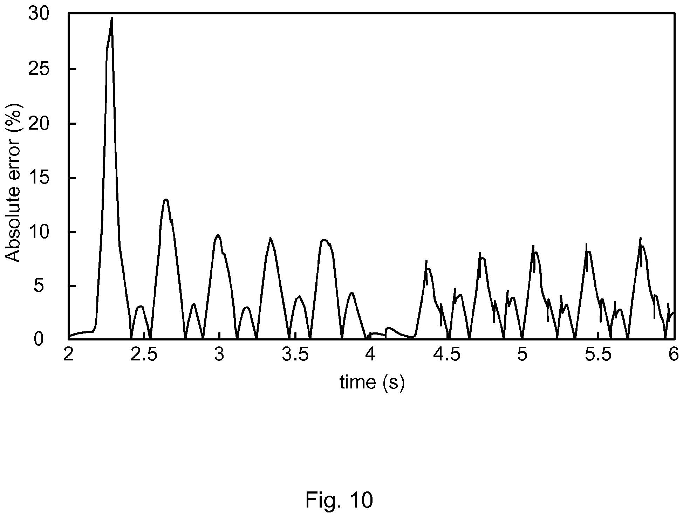

In Fig. 9 the SOC estimation performed in module 3 and also the real SOC based on accurate current integration form the test equipment. In Fig. 10 the absolute error (in %) of the SOC estimation is illustrated.

From Figs. 9 and 10 it is clear that during the last five cycles with forced excitation, the SOC estimation is more accurate than during the first five cycles. The root mean square error for the first time period without any forced excitation (20.000<t<40.000) is 0.0321 and for the second time period with the forced excitation pulses (40.000<t<60.000) it drops to 0.0183.

The invention has mainly been described above with reference to a few embodiments. However, as is readily appreciated by a person skilled in the art, other embodiments than the ones disclosed above are equally possible within the scope of the invention, as defined by the appended patent claims.

## Claims

1. A method for enabling dynamic evaluation of performance of a battery energy store, the method comprising:
measuring (2) real-time parameters (V, I, T) of a battery energy store (1);
estimating (3) a state of charge (SOC) for the battery energy store, the estimation being based on the measured real-time parameters and off-line data (4) of the energy store;
identification (3) of R-C parameters for an equivalent circuit model (ECM) of the battery energy store, the identification being based on the measured real-time parameters;
updating (5) a look-up table with the identified R-C parameters for different operating conditions; and
simulating (5) performance of the battery energy store based on two or more operating conditions.

2. The method according to claim 1, wherein the battery energy store is used to operate a marine vessel, such as propelling or positioning.

3. The method according to claim 1 or 2, wherein the battery energy store is a battery energy store system (BESS).

4. The method according to any one of claims 1 to 3, comprising estimating (3) a hybrid SOC parameter based on the estimated SOC and a SOC calculation.

5. The method according to claim 4, wherein, for estimation of the hybrid SOC parameter, the estimated SOC and the SOC calculation are combined weighted with a time parameter, such that for an older battery energy store the estimated SOC are more relevant than the calculated SOC, and for a newer battery energy store the calculated SOC is more relevant than the estimated SOC.

6. The method according to any one of claims 1 to 5, wherein the battery energy store comprises a plurality of batteries, the method comprising excitation of the battery energy store, including
increasing (1) a current charge/discharge for one or more of the plurality of batteries; and
decreasing (1) a current charge/discharge for one or more of the plurality of batteries;
wherein a total current charge/discharge for the plurality of batteries is kept unchanged.

7. The method according to claim 6, comprising
comparing (3) the total current before and after the excitation of the battery energy store to estimate SOC.

8. A system for enabling dynamic evaluation of performance of a battery energy store, the system comprising:
a battery energy store (1);
a real-time measurement module (2) for measuring real-time parameters (V, I, T) of the battery energy store;
an off-line data module (4) for storing off-line data of the battery energy store;
an state of charge (SOC) estimation module (3) for estimation of the SOC of the battery energy store, wherein the estimation being based on measured real-time parameters and off-line data of the energy store;
an identification module (3), wherein R-C parameters for an equivalent circuit model (ECM) of the battery energy store are identified, the identification being based on the measured real-time parameters;
an update module (5) for updating a look-up table with the identified R-C parameters for different operating conditions; and
a simulation module (5) for performance simulation of the battery energy store based on two or more operating conditions.

9. The system according to claim 8, wherein the battery energy store is for operating a marine vessel, such as propelling or positioning.

10. A marine vessel comprising the system of claim 8 or 9.

11. A computer program product for enabling dynamic evaluation of performance of a battery energy store, the computer program product comprising computer program code stored on a computer readable storage means, the computer program code, when run on a system, causes the system to:
measure (2) real-time parameters (V, I, T) of a battery energy store (1);
estimate (3) a state of charge (SOC) for the battery energy store, the estimation being based on the measured real-time parameters and off-line data (4) of the energy store;
identify (3) of R-C parameters for an equivalent circuit model (ECM) of the battery energy store, the identification being based on the measured real-time parameters;
update (5) a look-up table with the identified R-C parameters for different operating conditions; and
simulate (5) performance of the battery energy store based on two or more operating conditions.
